# EUROPEAN PATENT SPECIFICATION

(11) **EP 2 020 752 B1**
(45) Date of publication and mention of the grant of the patent: **02.03.2011**
(21) Application number: 08161542.9
(22) Date of filing: 31.07.2008
(51) Int. Cl.: H04B 1/04

(54) **Wireless system having high spectral purity**
Drahtloses System mit hoher Spektrumsreinheit
Système sans fil disposant d'une pureté spectrale élevée

(30) Priority: 02.08.2007 US 832960
(43) Date of publication of application: 04.02.2009
(73) Proprietor: Icera Canada ULC, 1200 Calgary, Alberta T2P 4V5 (CA)
(72) Inventor: Hughes, Simon, Waterloo Ontario N2K 2M5 (CA); Jantzi, Jason, Kitchener Ontario N2N 3N3 (CA); Uldry, Xavier, Waterloo Ontario N2L 5A7 (CA)
(74) Representative: Driver, Virginia Rozanne

(56) References cited:
- EP-A- 0 926 818
- WO-A-2006/137007
- US-A- 5 095 285
- US-A1- 2004 008 082
- US-A1- 2005 093 627

## Description

### FIELD OF THE INVENTION

The present invention relates generally to wireless communication. More particularly, the present invention relates to wireless devices having transmit functionality.

### BACKGROUND OF THE INVENTION

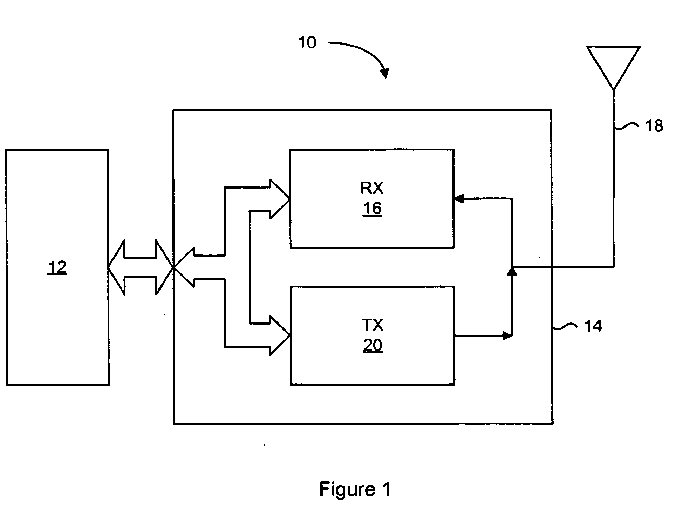

Wireless devices have been in use for many years for enabling mobile communication of voice and data. Such devices can include mobile phones and wireless enabled personal digital assistants (PDA's) for example. Figure 1 is a generic block diagram of the core components of such wireless devices. The wireless core **10** includes a baseband processor **12** for controlling application specific functions of the wireless device and for providing and receiving voice or data signals to a radio frequency (RF) transceiver chip **14.** The RF transceiver chip **14** is responsible for frequency up-conversion of transmission signals, and frequency down-conversion of received signals. RF transceiver chip **14** includes a receiver core **16** connected to an antenna **18** for receiving transmitted signals from a base station or another mobile device, and a transmitter core **20** for transmitting signals through the antenna **18.** Those of skill in the art should understand that Figure 1 is a simplified block diagram, and can include other functional blocks that may be necessary to enable proper operation or functionality. For example, wireless device **10** will have a power amplifier for amplifying signals from the transmitter core **20,** and a low noise amplifier for amplifying the signals received via the antenna **18.**

Generally, the transmitter core **20** is responsible for up-converting electromagnetic signals from baseband to higher frequencies for transmission, while receiver core **16** is responsible for down-converting those high frequencies back to their original frequency band when they reach the receiver, processes known as up-conversion and down-conversion respectively. The original (or baseband) signal may be, for example, data, voice or video. These baseband signals may be produced by transducers such as microphones or video cameras, be computer generated, or transferred from an electronic storage device. In general, the high frequencies provide longer range and higher capacity channels than baseband signals, and because high frequency radio frequency (RF) signals can propagate through the air, they are preferably used for wireless transmissions as well as hard-wired or fibre channels.

All of these signals are generally referred to as radio frequency (RF) signals, which are electromagnetic signals; that is, waveforms with electrical and magnetic properties within the electromagnetic spectrum normally associated with radio wave propagation.

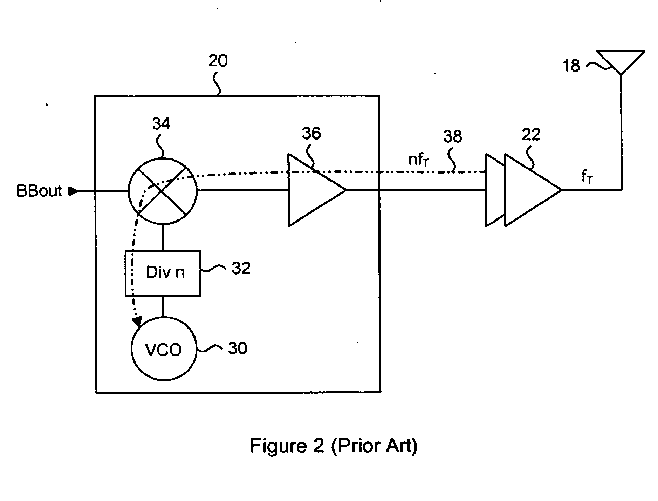

Figure 2 is a schematic showing further details of the transmitter core and its output path to the antenna **18.** The transmit path includes the transmitter core **20,** a power amplifier **22** and antenna **18.** Transmitter core **20** includes a voltage controlled oscillator (VCO) **30,** a divide-by-N circuit **32,** a mixer **34** and a pre-driver/amplifier **36.** Generally, the VCO **30** is set to provide an oscillating frequency signal that is a multiple of the output frequency provided by driver/amplifier **36.** For example, if the output frequency of driver/amplifier **36** is f_{T}, then the VCO can run at 4f_{T}. Divide-by-N circuit receives the VCO signal and divides it by N, in this example N=4, to feed the mixer **34.** Mixer **34** combines the data signal BBout from the baseband processor to generate the output signal at f_{T}, which is then provided to the power amplifier **22** for transmission via antenna **18.**

The RF transceiver **14,** and in particular the exemplary configuration of VCO **30,** divide-by-N circuit **32,** and mixer **34** of transmitter core **20** is known as a direct conversion architecture. The direct conversion architecture is versatile for generating narrowband signals for a plurality of standards, one being the GSM/GMSK standard for example. It is versatile because the same circuit can be used for different narrow band standards, thereby greatly simplifying multi-mode RF transceivers. Of course, each standard has specifications, such as transmit specifications, which must be met or exceeded by the mobile device. One specification for the GSM standard is the amount of allowable noise in adjacent and second adjacent channels, generated by the wireless device during a transmit operation. Unfortunately, an issue with direct conversion transmitter core architectures is its susceptibility to harmonics perturbations affecting VCO phase noise.

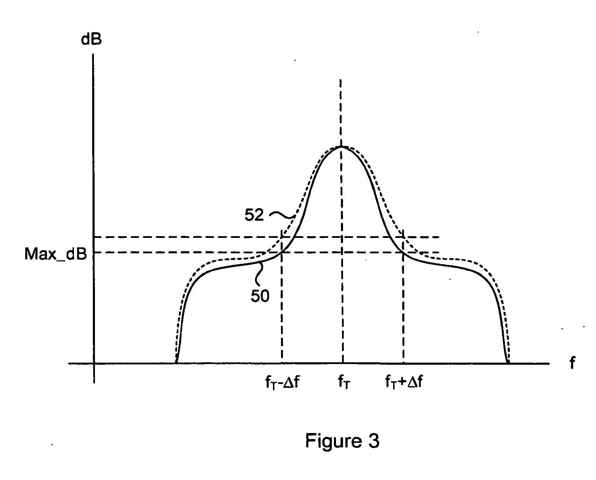

Through testing, it has been discovered that due to its non-linear characteristics, power amplifier **22** will generate harmonics in response to the output signal at f_{T}. In particular, one of the harmonics will be situated at 4f_{T} (nf_{T}), and will leak back into the transmitter core **14** and VCO **30,** as illustrated through leakage path **38.** This harmonic interference will leak into VCO **30** and degrade the phase noise of VCO **30,** which in turn degrades the downstream generation of the output signal provided to the power amplifier **22.** This performance degradation is illustrated In the graphical plot of noise (dB) vs frequency (f) in Figure 3.

In Figure 3, an ideal output response from the power amplifier 22 is plotted as curve 50. The desired signal at f_{T} should have high power or low loss, however the side bands should have minimized power. Some wireless standards may require that the maximum power of signals positioned below f_{T}-Δf and above f_{T}+Δf must not exceed Max_dB. The actual specifications for Δf and Max_dB can vary depending on the standard being used. In one example, Max_dB is -60dB and Δf is 400kHz. However, due to the leakage of harmonic noise from the power amplifier 22 back into the VCO 30, the spectral purity of the signal is degraded, resulting in the degraded output response of curve 52. Now the power at f_{T}-Δf and at f_{T}+Δf, where Δf is the modulation frequency offset, will be at a level that is greater than Max_dB. If the transceiver does not provide sufficient margin to account for this degradation, the device will fail to meet the required specification. The harmonics generated by the power amplifier are not limited to 4f_{T}, but can be at any frequency nf_{T}, where n is the order of harmonic, depending on the direct conversion architecture of the transmitter core. [0009] While there may be other sources of spectral degradation, they may be overshadowed by the degradation caused by the generation of harmonics by the power amplifier 22. It is, therefore, desirable to provide a wireless device that is immune to the harmonics generated by a power amplifier, to maintain spectral purity of the output signal.

WO 2006/137007 discloses an up-conversion transmitter which uses a harmonic filter to remove the need for mixing and 90 degree phase shifting. The transmitter comprises first and second analogue-to-digital converters for converting in-phase and quadrature signals to analogue, a summator for adding the in-phase and quadrature analogue signals, and a bandpass signal for suppressing harmonics in the signal output by the summator while passing the harmonic at a predetermined carrier frequency as the modulated signal. In this way, the need for mixing and 90 degree phase shifting is removed,

EP 0,926,818 discloses applying harmonic filtering to a signal before and after amplification, in order to reduce harmonics in the radio frequency signal that cause power interference between adjacent channels.

US 2005/0093627 discloses a circuit which removes a harmonic component of a signal input to power amplifier, in order to improve linearity of the power amplifier.

### SUMMARY OF THE INVENTION

It is an object of the present invention to obviate or mitigate at least one disadvantage of previous power supply rejection circuits.

In a first aspect, the present invention provides a wireless device. The wireless device includes a transmit circuit, a power amplifier and a harmonic trap. The transmit circuit provides an output signal at a transmit frequency. The power amplifier receives the output signal and provides an amplified output signal, such that the power amplifier generates harmonics at a specific frequency. The harmonic trap is configured to the output signal having the transmit frequency and to inhibit the harmonics generated by the power amplifier from leaking back into the transmit circuit.

According to embodiments of the present aspect,the specific frequency is an integer multiple of the transmit frequency, the harmonic trap can be a discrete device positioned in a path of the output signal between the transmit circuit and the power amplifier, or the harmonic trap can be integrated with the transmit circuit or the power amplifier.

In a further embodiment of the present aspect, the harmonic trap is a passive circuit which includes a capacitor configured to have a frequency response effective for attenuating the harmonics at the specific frequency. Alternately, the passive circuit includes a set of capacitors selectively enabled in parallel with each other to have a frequency response effective for attenuating the harmonics at the specific frequency. Alternately, the harmonic trap is an active circuit. In yet another embodiment, the transmit circuit and the power amplifier are soldered to a printed circuit board, and the harmonic trap is integrated in the printed circuit board as distributed transmission lines.

In a second aspect, the present invention provides a radio frequency transceiver for providing an output signal to a power amplifier. The radio frequency transceiver includes a transmitter core and a harmonic trap. The transmitter core generates the output signal at a transmit frequency. The harmonic trap passes the output signal having the transmit frequency, and inhibits harmonics at a specific frequency from entering the transmitter core, where the harmonics are generated by the power amplifier. According to embodiments of the present aspect, the specific frequency is an integer multiple of the transmit frequency, and the harmonic trap is either a passive circuit or an active circuit.

In a third aspect, the present invention provides a power amplifier for providing an amplified signal corresponding to an output signal received from a transmitter circuit. The power amplifier includes amplification circuitry and a harmonic trap. The amplification circuitry receives the output signal for generating the amplified signal, where the amplification circuitry generating harmonics at a specific frequency. The harmonic trap passes the output signal having a transmit frequency and inhibits the harmonics from passing to the transmitter circuit. In the present aspect, the specific frequency is an integer multiple of the transmit frequency.

Other aspects and features of the present invention will become apparent to those ordinarily skilled in the art upon review of the following description of specific embodiments of the invention in conjunction with the accompanying figures.

### BRIEF DESCRIPTION OF THE DRAWINGS

Embodiments of the present invention will now be described, by way of example only, with reference to the attached Figures, wherein:
Fig. 1 is a block diagram of core components of a wireless device;
Fig. 2 is a schematic of a transmit path of a wireless device of the prior art;
Fig. 3 is a graphical plot of power vs frequency for the output signal generated by the transmit path of Fig. 2;
Fig. 4 is a schematic of a transmit path having a discrete harmonic trap, according to an embodiment of the present invention;
Fig. 5 is a response curve for the harmonic trap shown in Figure 4;
Fig. 6 is a schematic of a transmit path having a harmonic trap integrated in a transmitter circuit, according to an embodiment of the present invention;
Fig. 7 is a schematic of a transmit path having a harmonic trap integrated in a power amplifier, according to an embodiment of the present invention;
Fig. 8 is a schematic of a harmonic trap, according to an embodiment of the present invention;
and,
Fig. 9 is a schematic of a transmit path having a harmonic trap integrated in the PCB.

### DETAILED DESCRIPTION

Generally, the present invention provides a wireless system having high spectral purity output signals. The wireless system has a transmitter circuit for transmitting an output signal and a power amplifier for amplifying the output signal for wireless transmission via an antenna. Positioned in-line with the output signal between the transmitter circuit and the power amplifier is a harmonic trap configured for inhibiting harmonics within a predetermined frequency range generated by the power amplifier from leaking into the transmitter circuit. The harmonic trap can be implemented as a discrete device, or integrated within the transmitter circuit or integrated within the power amplifier. By inhibiting the harmonics from leaking into the transmitter circuit, degraded performance of the transmitter circuit is prevented.

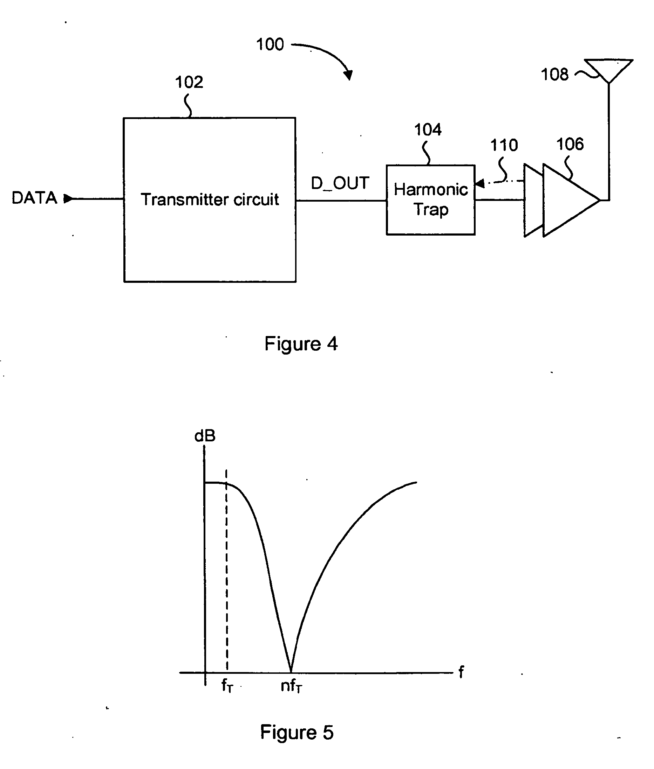

Figure 4 is a schematic of the transmit path of a wireless system **100,** according to an embodiment of the present invention. Wireless system **100** can include both a receive path and a transmit path, such as an RF transceiver, or just the transmit path. Wireless system **100** can be part of a mobile telephone, or any device with wireless communication capabilities. Those skilled in the art will understand that other circuits may be required to enable transmit path functionality, but are not shown to simplify the schematic as they are not relevant to the embodiments of the present invention. The presently illustrated transmit path includes a transmitter circuit **102,** a harmonic trap **104,** a power amplifier **106** and an antenna **108.** The general function of the components of the transmit path are now discussed in further detail.

The transmitter circuit **102** receives a baseband signal data and converts it into a particular communication standard, such as GSM for example, at a desired transmit RF frequency f_{T}. The converted output signal is referred to as D_OUT. Transmitter circuit **102** can be a direct conversion transmitter core of an RF transceiver, where it will include components corresponding to those shown in the transmitter core **20** of Figure 2. The harmonic trap **104** is connected in-line with the output signal D_OUT between the transmitter circuit **102** and the power amplifier **106.** Harmonic trap **104** is a bi-directional circuit configured to pass D_OUT at f_{T}, but will inhibit a specific range of frequencies from passing through it. In the present context, inhibiting refers to blocking passage of signals or attenuating signals. More specifically, harmonic trap **104** behaves as a filter having a specific response for reducing the power of harmonics at the specific frequencies. The specificity of the harmonic trap **104** can be tailored based on the specific direct conversion architecture implementation of the transmitter circuit **102,** and an understanding of the harmonics generated by the power amplifier **106.**

The power amplifier **106** is a standard component used for amplifying the D_OUT signal provided by the transmitter circuit **102.** This amplified signal is provided to the antenna **108** for wireless transmission. As previously mentioned, the power amplifier **106** has been identified as the source of generation of harmonics that can degrade performance of the transmitter circuit **102,** should the harmonics leak back into the transmitter circuit **102.** Since the most damaging harmonics generated by the power amplifier **106** are primarily at nf_{T}, where n is the division ratio of a divide-by-N circuit, similar to divide-by-N circuit 32,the configuration of the harmonic trap **104** for inhibiting harmonics will be set for nf_{T}. As shown in Figure 4, power amplifier **106** will continue to generate nf_{T} harmonics, which flow towards the transmitter circuit **102** and VCO in path **110.** However, due to harmonic trap **104,** the damaging harmonics are inhibited from passing through to the transmitter circuit **102** or VCO.

Once the frequency of the harmonics generated by power amplifier **106** is known to be at nf_{T}, several passive or active circuit can be designed according to known techniques in the art for preventing the harmonics from passing back into the transmitter circuit **102.** The attenuation vs frequency (f) response curve for the harmonic trap **104** is shown in Figure 5. As shown in Figure 5, the power at f_{T} is allowed to pass through the harmonic trap with low loss, but the power signal at nf_{T} drops to zero, or at least a neglible value insufficient for degrading performance of the transmitter circuit **102.** Any passive or active circuit having the response characteristic of Figure 5 will achieve the same result for the wireless system.

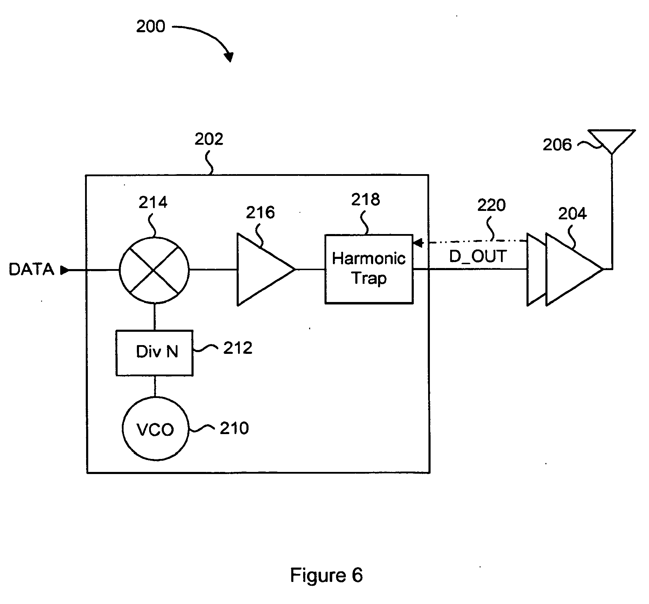

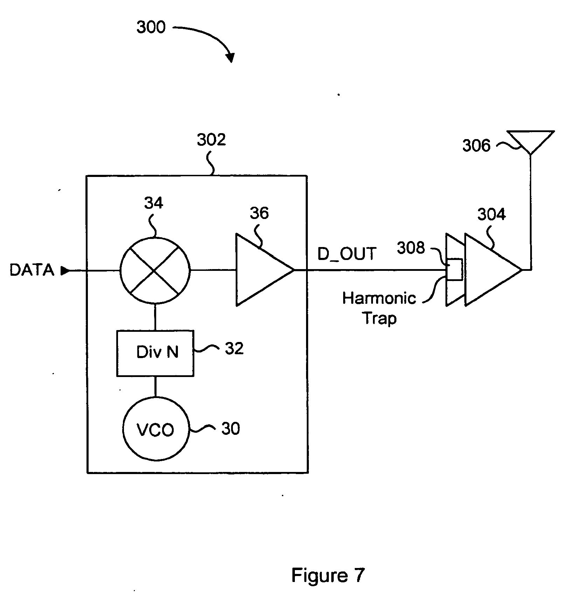

The embodiment of Figure 4 illustrates one transmit path implementation in a wireless system **100.** In most cases, the transmitter circuit **102,** power amplifier **104** and antenna are assembled together and soldered onto a printed circuit board (PCB), where each is a discrete component or set of components. For example, the transmitter circuit **102** can be part of an RF transceiver chip, and the power amplifier **102** can be fabricated on its own chip. According to alternate embodiments shown in Figure 6 and Figure 7, the harmonic trap can be integrated with the transmitter circuit **102** or the power amplifier **104.**

Figure 6 is a schematic of the transmit path of a wireless system **200,** according to an embodiment of the present invention. The presently illustrated transmit path includes a transmitter circuit **202,** a power amplifier **204** and an antenna **206.** The power amplifier **204** and the antenna **206** are the same as power amplifier **106** and antenna **108** of Figure 4. Generally, the transmitter circuit **202** receives data from an upstream circuit, such as a baseband processor for example, and converts the data into the designated format with the transfer frequency f_{T}. The presently shown transmitter circuit **202** inhibits harmonics generated by the power amplifier **204** from degrading the performance thereof. The details of transmitter circuit **202** are now discussed in further detail.

Transmitter circuit **202** includes direct conversion circuitry, such as VCO **210,** a divide-by-N circuit **212,** a mixer **214** and a driver/amplifier **216.** These components can be the same as the respective circuits shown in Figure 2. According to the present embodiment, a harmonic trap **218** is integrated onto the same chip as the direct conversion circuitry to pass the output of driver/amplifier **216.** The output signal D_OUT is provided from the output of harmonic trap **218** to power amplifier **204.** Power amplifier **204** will continue to generate harmonics at nf_{T}, which will flow towards the transmitter circuit **202** in path **220.** However, with the integrated harmonic trap **218** positioned in-line with the output signal between the direct conversion circuits, namely the driver/amplifier **216** and the power amplifier **204,** the harmonics will be inhibited from reaching any of the direct conversion circuits. The integrated harmonic trap **218** can be implemented as either a passive or active circuit configured for inhibiting passage of signals at nf_{T}.

Figure 7 is a schematic of the transmit path of a wireless system **300,** according to another embodiment of the present invention. The presently illustrated transmit path includes a transmitter circuit **302,** a power amplifier **304** and an antenna **306.** The transmitter circuit **302** and the antenna **306** are the same as transmitter circuit **20** and antenna **18** of Figure 2. The components of transmitter circuit **20** are numbered the same as those in Figure 2. Instead of being integrated with the transmitter circuit as illustrated in Figure 6, the harmonic trap **308** is integrated on the same chip as power amplifier **304,** in-line with the output signal D_OUT between the transmitter circuit **302** and the power amplification circuits of power amplifier **304.** Now, as the power amplification circuits generate harmonics at nf_{T}, they are attenuated by harmonic trap **308.** Therefore the harmonics never leak back to the transmitter circuit **302,** and in particular the VCO, with significant power.

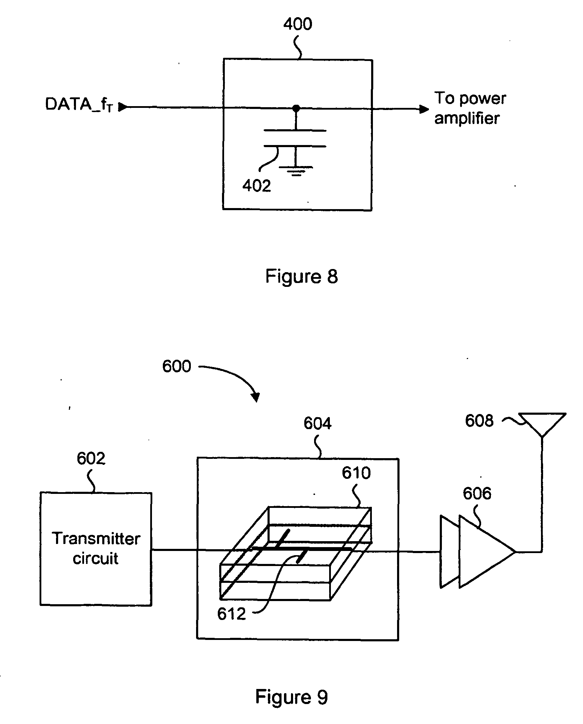

The previously discussed wireless system embodiments of Figures 4, 6 and 7 illustrate the possible system level implementations of the harmonic trap. The advantages of the embodiments of Figures 6 and 7 is the reduction in PCB area since a discrete harmonic trap is not required. Figures 8 to 9 now illustrate example embodiments of the harmonic trap which can be used in the wireless system embodiments of Figures 4, 6 and 7.

Figure 8 illustrates a generic implementation example of a harmonic trap. The harmonic trap **400** consists of a capacitor **402** having one terminal connected to the signal line between the transmitter circuit and the power amplifier, or between direct conversion circuits and the power amplifier, or between the transmitter circuit and the power amplification circuitry of a power amplifier. In either case, the capacitor **402** is connected to the signal line carrying data at the transmit frequency f_{T} (DATA_f_{T}). The other terminal of capacitor **402** is connected to ground. Those skilled in the art will understand that parameters and parasitic reactive impairments of capacitor **402** can be adjusted to arrive at a desired response to pass a first range of specific frequencies, while a second range of frequencies greater than the first range are rejected or attenuated from passing through the circuit. More specifically for the embodiments of the present invention, the harmonic trap **400** inhibits harmonics at this second range of frequencies from returning to the transmitter circuit.

The harmonic trap embodiments of Figure 8 is an example of a passive circuit which can be configured for inhibiting harmonics generated by the power amplifier from leaking back into the transmitter circuit. Those skilled in the art will understand that once the frequencies of the harmonics are known, then any passive circuit can be configured for inhibiting its passage. Active circuits and passive components arranged in known configurations can be used with equal effectiveness. While one capacitor **402** is shown, capacitor **402** can be implemented as a set of capacitors connected in parallel to each other. Furthermore, each capacitor can be selectively enabled or disabled change its response through simple switching means controlled by programmable registers or non-volatile programming means, such as fuses for example. Accordingly, the frequency response can be customized for the specific layout, configuration and devices of the system during a testing phase.

The transmit path embodiments of Figures 6 and 7 illustrate integration of the harmonic trap within other circuits, where the harmonic trap can be implemented as either passive or active components. In an alternate embodiment, the harmonic trap is integrated with the PCB itself. Figure 9 is a schematic illustrating a wireless system **600** having a transmitter circuit **602,** a harmonic trap **604,** a power amplifier **606** and antenna **606.** This embodiment does not require the use of any passive components, but uses distributed transmission lines in the PCB. In the wireless system, the transmitter circuit **602** and the power amplifier **606** are secured to a PCB **610.** The PCB will have at least two layers within which conductor lines are routed for interconnecting different devices. The output of the transmitter circuit **602** and the input of power amplifier **606** will be connected via a transmission line. This conducting line can have distributed branch conductor lines **612** that can be designed to provide a response as shown in Figure 5.

As shown in the embodiments of the present invention, a harmonic trap in series between a transmitter circuit and a power amplifier will be effective for inhibiting harmonics generated by the power amplifier from returning to the transmitter circuit. The harmonic trap can be implemented as a discrete device, or can be integrated within the transmitter circuit or the power amplifier to conserve PCB area.

The above-described embodiments of the invention are intended to be examples only. Alterations, modifications and variations can be effected to the particular embodiments by those of skill in the art without departing from the scope of the invention, which is defined solely by the claims appended hereto.

## Claims

1. A wireless device comprising:
a transmit circuit (102) for providing an output signal at a transmit frequency; and
a power amplifier (106) for receiving the output signal and providing an amplified output signal, the power amplifier generating harmonics at a specific frequency;
**characterized in that** the wireless device comprises:
a harmonic trap (104) configured to pass the output signal having the transmit frequency and to inhibit the harmonics generated by the power amplifier from leaking back into the transmit circuit, wherein the harmonic trap is a capacitor configured to have a frequency response effective for attenuating the harmonics at the specific frequency.

2. The wireless device of claim 1, wherein the specific frequency is an integer multiple of the transmit frequency.

3. The wireless device of claim 2, wherein:
the transmit circuit comprises: a voltage controlled oscillator (30,210) set to provide an oscillating frequency signal having a specific frequency, a divide-by-N circuit (32,212) arranged to divide the oscillating frequency signal and thus generate an output signal at a transmit frequency being an integer multiple N of the specific frequency, and a mixer (34,214) arranged to mix a data signal with the output signal of the divide-by-N circuit and thus provide an output signal at the transmit frequency;
the power amplifier (204,304) generates harmonics at the specific frequency of the voltage controlled oscillator, and the harmonic trap (218,308) is configured to inhibit the harmonics generated by the power amplifier at the specific frequency from leaking back into the voltage controlled oscillator.

4. The wireless device of any preceding claim, wherein the transmit circuit comprises a pre-driver amplifier (36,216) arranged to provide the output signal to the power amplifier (204,304), and wherein the harmonic trap (218,308) is positioned in line with the output signal between pre-driver amplifier and power amplifier.

5. The wireless device of claim 1, wherein the harmonic trap is a discrete device positioned in a path of the output signal between the transmit circuit and the power amplifier.

6. The wireless device of claim 1, wherein the harmonic trap is integrated with the transmit circuit.

7. The wireless device of claim 1, wherein the harmonic trap is integrated with the power amplifier.

8. The wireless device of claim 8, wherein the passive circuit includes a set of capacitors selectively enabled in parallel with each other to have a frequency response effective for attenuating the harmonics at the specific frequency.

9. The wireless device of claim 1, wherein the transmit circuit (602) and the power amplifier (606) are soldered to a printed circuit board (610), and the harmonic trap (604) is integrated in the printed circuit board as distributed transmission lines.

10. The wireless device of claim 1, wherein the wireless device is a radio frequency transceiver, and the transmit circuit is a transmitter core of the radio frequency transceiver.

## Patentansprüche

1. Eine drahtlose Vorrichtung mit:
einem Übertragungsschaltkreis (102) zum Liefern eines Ausgangssignals mit einer Übertragungsfrequenz; und
einem Leistungsverstärker (106) zum Empfangen des Ausgangssignals und
zum Liefern eines verstärkten Ausgangssignals, wobei der Leistungsverstärker Oberwellen mit einer spezifischen Frequenz generiert;
**dadurch gekennzeichnet, dass** die drahtlose Vorrichtung aufweist:
eine harmonische Falle (104), die so ausgestaltet ist, dass sie das Ausgangssignal mit der Übertragungsfrequenz durchlässt und die Oberwellen, die durch den Leistungsverstärker generiert werden, an einer Leckage zurück in den Übertragungsschaltkreis hindert, wobei die harmonische Falle ein Kondensator ist, der so ausgestaltet ist, dass er eine Frequenzantwort aufweist, die die Oberwellen bei der spezifischen Frequenz wirksam dämpft.

2. Die drahtlose Vorrichtung nach Anspruch 1, wobei die spezifische Frequenz ein ganzzahliges Vielfaches der Übertragungsfrequenz ist.

3. Die drahtlose Vorrichtung nach Anspruch 2, wobei:
der Übertragungsschaltkreis aufweist: einen spannungsgesteuerten Oszillator (30, 210), der so eingestellt ist, dass er ein Oszillationsfrequenzsignal mit einer spezifischen Frequenz liefert, einen Teile-durch-N Schaltkreis (32, 212), der angeordnet ist, um das Oszillationsfrequenzsignal zu unterteilen und **dadurch** ein Ausgangssignal mit einer Übertragungsfrequenz zu generieren, die ein ganzzahliges Vielfaches N der spezifischen Frequenz ist, und einen Mischer (34, 214), der angeordnet ist, um ein Datensignal mit dem Ausgangssignal des Teile-durch-N Schaltkreises zu mischen und **dadurch** ein Ausgangssignal mit der Übertragungsfrequenz zu liefern;
der Leistungsverstärker (204, 304) Oberwellen mit der spezifischen Frequenz des spannungsgesteuerten Oszillators generiert und die harmonische Falle (218, 308) so ausgestaltet ist, dass sie die durch den Leistungsverstärker mit der spezifischen Frequenz generierten Oberwellen an einer Leckage zurück in den spannungsgesteuerten Oszillator hindert.

4. Die drahtlose Vorrichtung nach einem vorhergehenden Anspruch, wobei der Übertragungsschaltkreis einen Vorantriebs-Verstärker (36, 216) aufweist, der angeordnet ist, um das Ausgangssignal zu dem Leistungsverstärker (204, 304) zu liefern, und wobei die harmonische Falle (218, 308) in Reihe mit dem Ausgangssignal zwischen dem Vorantriebsverstärker und dem Leistungsverstärker angeordnet ist.

5. Die drahtlose Vorrichtung nach Anspruch 1, wobei die harmonische Falle eine diskrete Vorrichtung ist, die in einem Weg des Ausgangssignals zwischen dem Übertragungsschaltkreis und dem Leistungsverstärker positioniert ist;

6. Die drahtlose Vorrichtung nach Anspruch 1, wobei die harmonische Falle mit dem Übertragungsschaltkreis integriert ist;

7. Die drahtlose Vorrichtung nach Anspruch 1, wobei die harmonische Falle mit dem Leistungsverstärker integriert ist.

8. Die drahtlose Vorrichtung nach Anspruch 8, wobei der passive Schaltkreis eine Gruppe von Kondensatoren aufweist, die wahlweise parallel zueinander in die Lage versetzt sind, eine Frequenzantwort aufzuweisen, die dazu dient, die Oberwellen bei der spezifischen Frequenz zu dämpfen.

9. Die drahtlose Vorrichtung nach Anspruch 1, wobei der Übertragungsschaltkreis (602) und der Leistungsverstärker (606) auf eine Schaltplatine (610) gelötet sind und wobei die harmonische Falle (604) als verteilte Übertragungsleitungen in die Schaltplatine integriert ist.

10. Die drahtlose Vorrichtung nach Anspruch 1, wobei die drahtlose Vorrichtung ein Radiofrequenztransceiver ist und wobei der Übertragungsschaltkreis ein Transmitterkern des Radiofrequenztransceivers ist.

## Revendications

1. Dispositif sans fil comprenant :
un circuit d'émission (102) pour produire un signal de sortie à une fréquence d'émission ; et
un amplificateur de puissance (106) pour recevoir le signal de sortie et produire un signal de sortie amplifié, l'amplificateur de puissance générant des harmoniques à une fréquence spécifique ;
**caractérisé en ce que** le dispositif sans fil comprend :
un piège harmonique (104) configuré pour faire passer le signal de sortie ayant la fréquence d'émission et inhiber la fuite des harmoniques générées par l'amplificateur de puissance de retour dans le circuit d'émission, dans lequel le piège harmonique est un condensateur configuré de manière à avoir une réponse en fréquence efficace pour atténuer les harmoniques à la fréquence spécifique.

2. Dispositif sans fil de la revendication 1, dans lequel la fréquence spécifique est un entier multiple de la fréquence d'émission.

3. Dispositif sans fil de la revendication 2, dans lequel :
le circuit d'émission comprend : un oscillateur commandé en tension (30, 210) configuré pour produire un signal à fréquence oscillante ayant une fréquence spécifique, un circuit de division par N (32, 212) configuré pour diviser le signal à fréquence oscillante et générer ainsi un signal de sortie à une fréquence d'émission étant un entier N multiple de la fréquence spécifique, et un mélangeur (34, 214) configuré pour mélanger un signal de données avec le signal de sortie du circuit de division par N et produire ainsi un signal de sortie à la fréquence d'émission ;
l'amplificateur de puissance (204, 304) génère des harmoniques à la fréquence spécifique de l'oscillateur commandé en tension, et le piège harmonique (218, 308) est configuré pour inhiber la fuite des harmoniques générées par l'amplificateur de puissance à la fréquence spécifique de retour dans l'oscillateur commandé en tension.

4. Dispositif sans fil de l'une quelconque des revendications précédentes, dans lequel le circuit d'émission comprend un amplificateur préexcitateur (36, 216) configuré pour transmettre le signal de sortie à l'amplificateur de puissance (204, 304), et dans lequel le piège harmonique (218, 308) est positionné en ligne avec le signal de sortie entre l'amplificateur préexcitateur et l'amplificateur de puissance.

5. Dispositif sans fil de la revendication 1, dans lequel le piège harmonique est un dispositif discret positionné dans un trajet du signal de sortie entre le circuit d'émission et l'amplificateur de puissance.

6. Dispositif sans fil de la revendication 1, dans lequel le piège harmonique est intégré au circuit d'émission.

7. Dispositif sans fil de la revendication 1, dans lequel le piège harmonique est intégré à l'amplificateur de puissance.

8. Dispositif sans fil de la revendication 8, dans lequel le circuit passif comprend un ensemble de condensateurs sélectivement activés en parallèle les uns avec les autres de manière à avoir une réponse en fréquence efficace pour atténuer les harmoniques à la fréquence spécifique.

9. Dispositif sans fil de la revendication 1, dans lequel le circuit d'émission (602) et l'amplificateur de puissance (606) sont soudés à une carte de circuit imprimé (610), et le piège harmonique (604) est intégré dans la carte de circuit imprimé sous la forme de lignes d'émission distribuées.

10. Dispositif sans fil de la revendication 1, dans lequel le dispositif sans fil est un émetteur-récepteur de radiofréquence, et le circuit d'émission est un noyau émetteur de l'émetteur-récepteur de radiofréquence.
